# EUROPEAN PATENT APPLICATION

(11) **EP 4 261 035 A1**
(43) Date of publication of application: **18.10.2023**
(21) Application number: 23166083.8
(22) Date of filing: 31.03.2023
(51) Int. Cl.: B32B 15/01, C25D 5/12, C22C 5/06, C25D 7/00

(54) **ARTICLE WITH A SILVER TOPCOAT FOR HIGH TEMPERATURE APPLICATIONS**

(30) Priority: 12.04.2022 US 202217718941
(71) Applicant: Rohm and Haas Electronic Materials LLC, Marlborough, MA 01752 (US); DDP Specialty Electronic Materials US, LLC, Wilmington, DE 19805 (US)
(72) Inventor: FOYET, Adolphe, 6014 Luzern (CH); CLAUSS, Margit, 6010 Kriens (CH); LIPSCHUTZ, Michael, Framingham, 01701 (US)
(74) Representative: Houghton, Mark Phillip

(57) **Abstract**

An article and a method of making the article is disclosed where the article includes a sequence of metal layers arranged to inhibit adhesion failure between the metal layers. The metal layers include a topcoat of silver, an intermediate layer of silver, a silver-tin alloy layer and a nickel layer. The layers adhere to a substrate containing copper or copper alloy.

## Description

### Filed of the Invention

The present invention is directed to high temperature resistant silver coated substrates for high temperature applications. More specifically, the present invention is directed to high temperature resistant silver coated substrates for high temperature applications containing a sequence of silver, silver-tin and nickel or nickel alloy layers adjacent a copper or copper alloy substrate with improved adhesion.

### Background of the Invention

Silver finishing is widely used for electronic components because of the high electrical conductivity, good solderability and corrosion resistance. For connector applications, a copper alloy is first coated with nickel followed by a silver finishing layer. Nickel acts as a barrier layer to prevent copper diffusion in silver and preserving the electrical properties of the silver functional layer. This combination worked for many years in the electronic industry for low temperatures of about -10 °C to about 35 °C and medium operating temperatures of about 36 °C to about 100 °C. With the advancement of technology, such as in electric vehicles, operating temperatures have increased substantially at some electrical connectors.

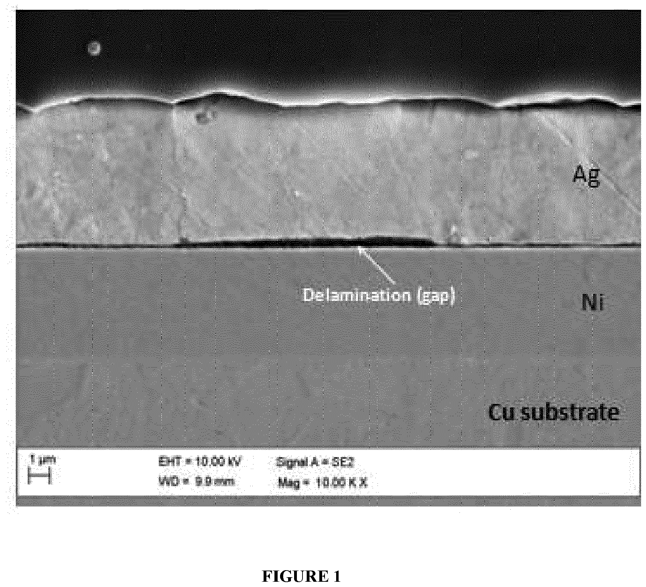

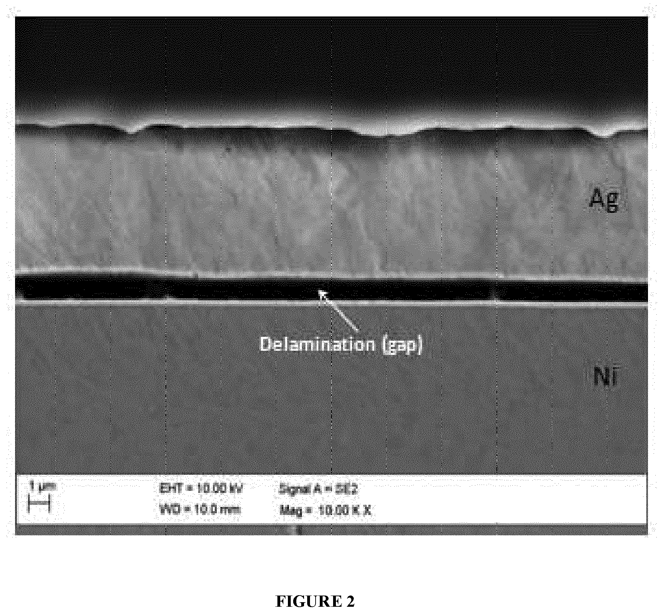

There has recently been increased interest by different industries to use silver coatings for high temperature applications, typically at temperatures above 150 °C. At such high temperatures the use of a nickel barrier layer is essential because of rapid copper diffusion to the silver layer. In addition, under such high temperature conditions, oxidation of nickel underneath the silver can readily occur resulting in adhesion failure between the nickel and the silver. This is illustrated in both **Figure 1** and **Figure 2****.** **Figure 1** is a cross section of a copper substrate with an electroplated nickel layer of about 3µm coated with an electroplated silver layer of about 4µm. The nickel layer is coated with a very thin gold strike layer of about 10-20nm to attempt to inhibit oxygen diffusion down to the nickel layer to prevent nickel oxidation. After 1000 hours of exposure at 200 °C, a substantial gap developed at the interface of the silver and nickel layers significantly compromising adhesion between the silver and nickel layers. **Figure 2** illustrates another example of adhesion failure between silver and nickel layers exposed to high temperatures for prolonged periods. **Figure 2** is a cross section of a copper substrate with an electroplated nickel layer of about 3µm coated with an electroplated silver layer of about 4µm. The nickel layer is coated with a very thin palladium strike layer of about 10-20nm also as an attempt to inhibit nickel oxidation. After about 1000 hours of exposure at about 200 °C, a substantial gap developed at the interface of the silver and nickel layers significantly compromising adhesion between the silver and nickel layers.

The phenomenon of accelerated oxidation of the nickel under silver at high temperatures is not yet fully understood. It appears to be caused by diffusion of oxygen through the silver grain boundary. Conventional methods used to enhance the silver adhesion to nickel, such as gold, palladium or silver strike and nickel surface activation have not been able to overcome the oxidation and adhesion problem at high temperature applications as illustrated in **Figures 1-2** for gold and palladium strike layers. Accordingly, there is a need for improved metal articles with silver layers for high temperature applications.

### Summary of the Invention

An article includes a substrate containing copper or copper alloy, a nickel layer or nickel alloy layer adjacent the copper or copper alloy of the substrate, a silver undercoat layer adjacent the nickel layer or nickel alloy layer, a silver-tin alloy layer adjacent the silver undercoat layer and a silver topcoat layer adjacent the silver-tin alloy layer.

A method includes:
a) providing a substrate comprising copper or copper alloy;
b) depositing a nickel layer or nickel alloy layer adjacent the copper or copper alloy of the substrate;
c) depositing a silver undercoat layer adjacent the nickel layer or nickel alloy layer;
d) depositing a silver-tin alloy layer adjacent the silver undercoat layer; and
e) depositing a silver topcoat layer adjacent the silver-tin alloy layer.

The article of the present invention has good adhesion properties between the metal layers and has good contact resistance even at high temperatures.

### Brief Description of the Drawings

**Figure 1** is a 10,000X SEM cross-section of a silver layer on a gold strike coated nickel layer showing a substantial gap at the silver and nickel interface after 1000 hours of storage at 200° C.
**Figure 2** is a 10,000X SEM cross-section of a silver layer on a palladium strike coated nickel layer showing a substantial gap between the silver and nickel interface after 1000 hours of storage at 200° C.
**Figure 3** is an illustration of a cross-section of an article with a silver topcoat layer adjacent a silver-tin alloy layer adjacent a silver undercoat layer which is adjacent a nickel barrier layer and the nickel barrier layer is adjacent a copper based substrate.
**Figure 4** is a 15,000X SEM cross-section of a silver topcoat layer adjacent to silver-tin alloy layer adjacent to silver undercoat layer adjacent to nickel layer which is adjacent a copper alloy substrate at room temperature.
**Figure 5** is a 807X SEM of a nickel coated copper substrate with silver layers showing adhesion failure of the silver layers from nickel after thermal aging for 500 hours at 200 °C.
**Figure 6** is a 15,000X SEM cross-section of a silver topcoat layer adjacent to silver-tin alloy layer adjacent to silver undercoat layer adjacent to nickel layer which is adjacent to a copper alloy containing substrate after 1000 hours of storage at 200° C.
**Figure 7** is a 1040X SEM of a nickel coated copper substrate with silver layers showing adhesion failure of the silver layers from nickel after thermal aging for 1000 hours at 200 °C.

As used throughout this specification, the terms "electroplating", "depositing" and "plating" are used interchangeably. The terms "composition" and "bath" are used interchangeably throughout the specification. The term "adjacent" means adjoining or next to and joined with where adjacent layers have a common interface. The term "copper-based substrate" means the substrate includes at least copper or copper alloys and can include other materials such as additional metals, plastics, resins, or other organic and dielectric materials. The term "contact resistance" means the contribution to total resistance to current flow of a system which can be attributed to contacting interfaces of electrical leads and connections. A "Newton" is an SI unit of force which is equal to the force that would give a mass of one kilogram an acceleration of one meter per second per second and is equivalent to 100,000 dynes. The term "Ohm" means the SI unit of electrical resistance, expressing the electrical resistance in a circuit transmitting a current of one ampere when subjected to a potential difference of one volt. The term "aliquot" means a portion of a larger whole, especially samples taken for chemical analysis or other treatment. The term "normal force" means a force that surfaces exert to prevent solid objects from passing through each other. The indefinite articles "a" and "an" are intended to include both the singular and the plural.

The following abbreviations have the following meanings unless the context clearly indicates otherwise: °C = degrees Celsius; g = grams; mL = milliliter; L = liter; ASD = A/dm² = amperes/decimeter squared; PVD = physical vapor deposition; CVD = chemical vapor deposition; PCB = printed circuit board or printed wiring board; SEM = scanning electron micrograph; EDX = EDS = energy-dispersive X-ray spectroscopy; ASTM = American Standard Testing Method; mN = milli-Newtons; mOhms = milli-Ohms; cm = centimeter; µm = microns; nm = nanometers; Ag = silver; Sn = tin; Ni = nickel; Cu = copper; EX = example and NA = not available.

All percentages and ratios are by weight unless otherwise indicated. All ranges are inclusive and combinable in any order except where it is logical that such numerical ranges are constrained to add up to 100%.

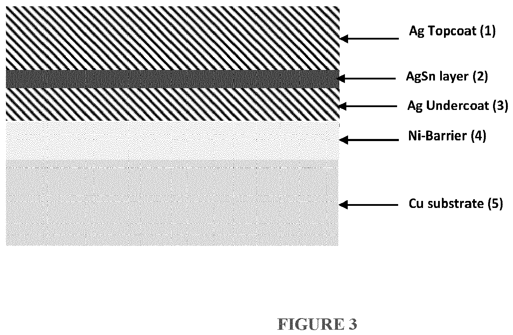

**Figure 3** illustrates an article of the present invention having a silver topcoat **1** adjacent to a silver-tin alloy layer **2** adjacent to a silver undercoat layer **3** adjacent to a nickel containing barrier layer **4** which is adjacent to a copper-based substrate **5.** Optionally, the silver topcoat layer can have an anti-tarnish layer (not shown). The articles can be used as components in various electronic devices, such as those devices where the article may be exposed to temperatures of 150 °C and higher such as 200 °C and still retain good adhesion between the metal layers.

One or more layers of nickel or nickel alloy are deposited on a substrate which includes copper. The nickel functions as a barrier layer to inhibit copper diffusion into a silver top layer. The substrate can be substantially all copper or can include one or more copper alloys such as, but not limited to, copper-tin, copper-silver, copper-gold, copper-bismuth, copper-zinc, copper-nickel, copper-tin-silver and copper-tin-bismuth. Preferably, the substrate is copper, copper-zinc or copper-bismuth. The substrate can be a PCB or dielectric material, such as a plastic or resin material, with a copper or cooper alloy layer. The nickel or nickel alloy is deposited such that the layers are adjacent a surface of the copper or copper alloy layer of the substrate to form an interface with the copper or copper alloy surface. Preferably, the nickel or nickel alloy layers are at least 0.5µm thick, or such as from 0.5µm to 10µm thick, or such as from 1µm to 5µm thick. The one or more nickel or nickel alloy layers can be deposited by conventional methods used in the art to deposit nickel or nickel alloys on a substrate. Most preferably, a nickel layer is deposited adjacent the copper or copper alloy layer of the substrate. Such methods include, but are not limited to, PVD, CVD, electrolytic and electroless metal plating. Such methods are well known in the art and literature. Preferably, electrolytic metal plating is used to deposit the nickel or nickel alloy adjacent the copper or copper alloy of the substrate.

Preferably, nickel or nickel alloy electroplating can be done at a current density of at least 0.01 ASD. More preferably, current densities are from 0.1 ASD to 15 ASD, even more preferably, from 0.5 ASD to 6 ASD. Minor experimentation can be used to tailor the current density for a specific substrate. The electroplating processes used can be conventional.

Nickel ions in the plating compositions can be provided by using any suitable solution-soluble nickel compound, preferably, a water-soluble nickel salt. Such nickel compounds include, but are not limited to, nickel sulfate, nickel chloride, nickel sulfamate, and nickel phosphate. Mixtures of nickel compounds can be used in the plating compositions. Preferably, the nickel compounds are added to the plating compositions in an amount sufficient to provide a nickel ion concentration in the plating composition of 0.1 g/L to 150 g/L, or such as from 0.5 g/L to 100 g/L, or such as from 1 g/L to 70 g/L.

A wide variety of electrolytes can be used in the nickel plating compositions, including acids and bases. Acid electrolytes include, without limitation, alkane sulfonic acids such as methane sulfonic acid, ethane sulfonic acid and propane sulfonic acid; alkylol sulfonic acids; aryl sulfonic acids such as toluene sulfonic acid, phenyl sulfonic acid and phenol sulfonic acid; amino-containing sulfonic acids such as amido sulfonic acid; sulfamic acid; mineral acids; carboxylic acids such as formic acid and haloacetic acids; hydrogen halide acids; and pyrophosphate. Salts of acids and bases also can be used as the electrolyte. Further, the electrolyte can contain a mixture of acids, a mixture of bases or a mixture of one or more acids with one or more bases. Such electrolytes are generally commercially available from a variety of sources, such as Aldrich Chemical Company, Milwaukee, Wisconsin.

Optionally a wide variety of surfactants can be used in the nickel plating compositions. Any of anionic, cationic, amphoteric and nonionic surfactants can be used as long as it does not interfere with the performance of the nickel plating. Surfactants can be included in conventional amounts, such are well known in the art.

Optionally, the nickel plating compositions can contain one or more additional components. Such additional components include, without limitation, brighteners, grain refiners and ductility enhancers. Such additional components are well known in the art and are used in conventional amounts.

The nickel plating composition can optionally contain a buffering agent. Exemplary buffering agents include, but are not limited to, borate buffer (such as borax), phosphate buffer, citrate buffer, carbonate buffer, and hydroxide buffer. The amount of the buffer used is that amount sufficient to maintain the pH of the plating composition at a desired level, such amounts being well known to those skilled in the art.

One or more alloying metals can be included in the nickel plating compositions. Such alloying metals include without limitation tin, copper and bismuth. Nickel-phosphorus is a preferred alloy. Such metals are provided as their solution soluble salts which are well known in the art. Conventional amounts can be included in the nickel plating compositions to provide a nickel alloy deposit. Preferably, alloying metals are excluded from the nickel plating baths.

Suitable electrolytic nickel plating baths are commercially available as well as many which are disclosed in the literature. Examples of commercially available electrolytic nickel baths are the NICKEL GLEAM^{™} Electrolytic Nickel products and NIKAL^{™} SC Electrolytic Nickel products both obtainable from Rohm and Haas Electronic Materials, LLC, Marlborough, MA, U.S.A. Additional examples of electrolytic nickel plating baths are the Watts-type baths disclosed in U.S. 3,041,255.

Electroless nickel plating compositions can include a reducing agent. Preferably, the electroless nickel plating compositions include a reducing agent. Such reducing agents include, but are not limited to, sodium hypophosphite, potassium hypophosphite, thiourea and thiourea derivatives, hydantoin and hydantoin derivatives, hydroquinone and hydroquinone derivatives, resorcinol, and formaldehyde and formaldehyde derivatives, DEA (n-diethyl-amine borane), sodium borohydride and hydrazine. Such reducing agents can be used in conventional amounts such as from 0.1 g/L to 40 g/L. Examples of commercially available electroless nickel compositions include DURAPOSIT^{™} SMT 88 Electroless Nickel and NIPOSIT^{™} PM 980 and PM 988 Electroless Nickel. All are available from Rohm and Haas Electronic Materials, LLC.

Nickel plating compositions can have a pH in the range of 1 to 14, preferably, from 1 to 12, more preferably, from 1-8. The working temperature of the nickel plating compositions during plating can be from 10 °C to 100 °C, or such as from 20 °C to 50 °C.

Following deposition of the nickel or nickel alloy one or more silver undercoat layers are deposited adjacent to the one or more nickel or nickel alloy layers. silver can be deposited by conventional methods used in the art, such as electrolytic, electroless or immersion silver plating. Preferably silver is electroplated or electrolessly plated adjacent the nickel or nickel alloy. More preferably silver is electroplated adjacent the nickel or nickel alloy layer. The silver undercoat layers, preferably, have a thickness of at least 0.01µm, or such as from 0.05µm to 2µm, or such as from 0.1µm to 2µm, or such as from 0.1µm to 1µm.

Conventional electroplating silver compositions can be used. The silver compositions can be cyanide containing silver compositions or cyanide-free silver compositions. When cyanide containing silver compositions are used to plate silver, preferably, the silver compositions are alkaline. Sources of silver ions include, without limitation: silver potassium cyanide, silver nitrate, silver sodium thiosulfate, silver gluconate; silver-amino acid complexes such as silver-cysteine complexes; silver alkyl sulfonates, such as silver methane sulfonate. Mixtures of silver compounds may be used. The concentration of silver ions in the composition is preferably 2 g/L to 60 g/L. Such silver compounds can be commercially available from a variety of sources, such as Aldrich Chemical Company, Milwaukee, Wisconsin. Examples of commercially available silver plating compositions are SILVER GLO^{™} 3K Silver Electroplating bath, SILVERJET^{™} 300 Silver Electroplating bath, SILVER GLEAM^{™} 360 Silver Electroplating bath, ENLIGHT^{™} Silver Plate 600 and 620 from Rohm and Haas Electronic Materials, LLC.

A wide variety of conventional surfactants can be used in the silver plating compositions, such as anionic, cationic, amphoteric and nonionic surfactants. Surfactants can be included in conventional amounts. The silver plating compositions can contain one or more additional conventional components. Such additional components include, without limitation, electrolytes, buffers, brighteners, grain refiners, chelating agents, complexing agents, reducing agents, levelers and ductility enhancers. Such additional components are well known in the art and are used in conventional amounts.

Silver plating compositions can have a pH in the range of 1 to 14, preferably, from 1 to 12, and still more preferably, from 1-10. The working temperature of the silver plating compositions during silver plating is from 10 to 100 °C, or such as from 20 to 60 °C. Preferred current densities are from 0.1 ASD to 50 ASD, more preferably, from 1 ASD to 20 ASD.

Preferably, the silver undercoat layer is equal to or greater in thickness than the subsequent silver-tin alloy layer. The silver undercoat layer inhibits the formation of an intermetallic of nickel and tin from the subsequent silver-tin alloy layer. Further, the silver undercoat layer inhibits the formation of undesired Kirkendal voids at the nickel interface which can result in adhesion failure of the article over prolonged used. Preferably, a thickness ratio of the silver undercoat layer to the silver-tin alloy layer is within a range of 1:1 to 20:1 or higher, more preferably, with a range of 1:1 to 40: 1.

The silver-tin alloy layer deposited adjacent to the silver undercoat layer is rich in silver content with at least 60wt% silver with the remainder tin. The silver-tin alloy layer is ductile and can inhibit oxygen diffusion to the nickel surface to prevent or reduce corrosion. Preferably, the silver-tin alloy is electroplated on the silver undercoat layer. Conventional silver-tin alloy electroplating baths can be used. An example of a commercially available silver-tin alloy electroplating bath is SILVERON^{™} GT-820 silver-tin alloy electroplating bath available from Rohm and Haas Electronic Materials LLC.

The silver-tin alloy electroplating baths include one or more sources of silver ions. Sources of silver ions include, without limitation, water-soluble silver salts such as silver halides, silver gluconate, silver citrate, silver lactate, silver nitrate, silver sulfates, silver alkane sulfonates and silver alkanol sulfonates. When a silver halide is used, preferably, the halide is chloride. Preferably, the silver salts are silver sulfate, a silver alkane sulfonate or mixtures thereof, more preferably silver sulfate, silver methane sulfonate or mixtures thereof. The silver salts are generally commercially available or can be prepared by methods described in the literature. The amounts of the one or more silver salts used in the baths depend, for example, on the desired alloy composition to be deposited and operating conditions. Preferably, silver salts in the bath are from 1 g/L to 100 g/L, preferably, from 10 g/L to 80 g/L.

Sources of water-soluble tin ions include, without limitation, tin halides, tin sulfates, tin alkane sulfonates, tin alkanol sulfonates, and acids. When tin halide is used, preferably, the halide is chloride. Preferably, the source of tin ions is tin sulfate, tin chloride or a tin alkane sulfonate, more preferably, the source of tin ions is tin sulfate or tin methane sulfonate. The tin compounds are generally commercially available or can be prepared by methods known in the literature. Amounts of tin salts used in the bath depends on the desired composition of the alloy to be deposited and operating conditions. Preferably, tin salts range from 0.01 g/L to 80 g/L, more preferably, from 0.5 g/L to 40 g/L.

Silver-tin alloy baths can be acidic or alkaline. Preferably, the silver-tin alloy baths are acidic. Acid electrolytes include, but are not limited to, alkane sulfonic acids, such as methane sulfonic acid, ethane sulfonic acid and propane sulfonic acid, aryl sulfonic acids, such as phenyl sulfonic acid, phenol sulfonic acid and toluene sulfonic acid, sulfuric acid, sulfamic acid, hydrochloric acid, hydrobromic acid, fluoroboric acid and mixtures thereof. Such acid electrolytes can be included in conventional amounts. Preferably, acid electrolytes are included in amounts of 10 g/L to 400 g/L, more preferably, from 50 g/L to 400 g/L. Such silver-tin alloy baths have a pH of less than 2, preferably, less than 1.

Conventional surfactants can be included in the silver-tin alloy plating compositions, such as anionic, cationic, amphoteric and nonionic surfactants. Surfactants can be included in conventional amounts. The silver-tin alloy plating compositions can contain one or more additional conventional components. Such additional components include, without limitation, electrolytes, buffers, brighteners, grain refiners, chelating agents, complexing agents, reducing agents, levelers and ductility enhancers. Such additional components are well known in the art and are used in conventional amounts.

Preferably, the current density for depositing silver-tin alloy is 0.05 ASD or greater, more preferably, from 1 ASD to 25 ASD. The silver-tin alloys can be electroplated at temperatures from room temperature to 55 °C, or such as from room temperature to 40 °C, or such as from room temperature to 30 °C.

The baths can be used to deposit silver-tin alloys rich in silver of various compositions. Preferably, the silver-tin alloy has a silver content of 60wt% to 95% with the remainder tin, more preferably, the silver content ranges from 70wt% to 90wt% with the remainder tin, most preferably, the silver content is from 75wt% to 85wt% with the remainder tin.

A silver topcoat layer is then deposited adjacent the silver-tin alloy layer. The silver topcoat layer is, preferably, at least 1µm thick, or such as from 1µm to 20µm thick, or such as from 1µm to 10µm thick, or such as from 1µm to 5µm thick. The silver topcoat layer enables good electrical conductivity of the article with a low contact resistance, even after exposure to high temperatures of 200 °C and higher over prolonged periods of time such as 1000 hours or longer.

Conventional silver deposition compositions and methods described above for depositing the silver undercoat layer can be used to deposit the silver topcoat layer adjacent the silver-tin alloy layer. Preferably, the silver topcoat layer is deposited adjacent the silver-tin alloy layer by electroplating silver using the silver electroplating compositions described above. The silver compositions can be cyanide containing silver compositions or cyanide-free silver compositions. Silver electroplating is done under the same parameters of temperature and current density as described above for the silver undercoat layer. Silver electroplating is done until a desired thickness of silver is achieved for the topcoat layer. Preferably, silver electroplating is done until a thickness ratio of the silver topcoat layer to the silver-tin alloy layer is within a range of 2:1 to 100:1, more preferably, within a range of 3:1 to 30:1, even more preferably, within a range of 6:1 to 12:1.

Optionally, an anti-tarnish layer can be deposited on the silver topcoat layer. Conventional anti-tarnish compositions can be used. Commercial examples of such ant-tarnish materials are NO-TARN^{™} PM 3 Anti-tarnish formulation, PORE BLOCKER^{™} 100 Anti-tarnish formulation and PORE BLOCKER^{™} 200 Anti-tarnish formulation (available from Rohm and Haas Electronic Materials, LLC).

Preferably, there is no gold, palladium, or other metal layer(s), such as a flash layer(s), on the silver topcoat layer of the article of the present invention. The silver topcoat eliminates a need for such additional metal layer(s) or flash layer(s). Further preferably, the article of the present invention consists of a silver topcoat layer adjacent to a silver-tin alloy layer adjacent to a silver undercoat layer adjacent to a nickel containing barrier layer which is adjacent to a copper-based substrate and optionally an anti-tarnish layer adjacent to the silver topcoat layer. More preferably, the article of the present invention consists of a silver topcoat layer adjacent to a silver-tin alloy layer adjacent to a silver undercoat layer adjacent to a nickel containing barrier layer which is adjacent to a copper-based substrate and optionally an anti-tarnish layer adjacent to the silver topcoat layer, wherein the silver topcoat layer is thicker than the silver-tin layer and the silver undercoat layer is equal in thickness or greater in thickness than the silver-tin alloy layer. Even more preferably, the article of the present invention consists of a silver topcoat layer adjacent to a silver-tin alloy layer adjacent to a silver undercoat layer adjacent to a nickel containing barrier layer which is adjacent to a copper-based substrate and optionally an anti-tarnish layer adjacent to the silver topcoat layer, wherein a thickness ratio of the silver topcoat layer to the thickness of the silver-tin alloy layer is 2:1 to 100:1 and a thickness ratio of the silver undercoat layer to the silver-tin alloy layer is, preferably, 1:1 to 20:1 or greater, more preferably, 1:1 to 40:1.

A silver topcoat layer with a thickness ratio of 2:1 to 100:1 to the thickness of the silver-tin layer enables low contact resistance for the article, thus improving electrical conductivity, and a silver undercoat layer with a thickness ratio of, preferably, 1:1 to 20: 1 or greater, more preferably,1:1 to 40:1 to the thickness of the silver-tin layer inhibits Kirkendal voids and NiSn intermetallic formation improving adhesion of the metal layers of the article. Further, a silver-tin alloy layer with a thickness of 0.05µm and greater is believed to prevent undesired oxygen diffusion to the nickel or nickel alloy layer. Oxidation of nickel or nickel alloy layers can be measured using standard EDS or EDX analysis methods well known in the art.

The articles of the present invention can be used in low and in high temperature environments with minimal concern for adhesion failure of the metal layers. The articles can be used as parts or components in PCBs, electrical connectors, light emitting diodes (LEDs), electric vehicles and other applications where silver layers can be exposed to temperatures of 150° C and higher.

The following examples are included to illustrate the invention but are not intended to limit the scope of the invention.

### Examples 1-7

The thickness of the electroplated silver and silver-tin alloy layers was measured using a Fisherscope model XDV-SD X-Ray Fluorimeter (XRF) available from Fischer. The XRF was calibrated using pure element thickness standards for silver and tin from Bowman and calculated silver and silver-tin alloy composition and thickness by combining the pure element standards with Fundamental Parameter (FP) calculations from the XRF instruction manual.

Cross Hatch adhesion tests were done according to ASTM D3359 which is a standard test method for measuring adhesion with tape. The test assesses the adhesion of film coatings to metallic substrates by applying and removing pressure sensitive tape over cuts made in the film by an appropriate tool such as a knife or razor blade. A non-standard pin bending method (frequently applied at production lines) was also used to assess adhesion of metal layers. The method involved bending a pin to about a 90-degree angle and then observing the external side (where expansion of material occurs) and the internal side of the bended pins (where the compression of the material occurs) through an optical microscope to identify any pealing of layers.

Contact resistance before and after thermal aging was evaluated using a KOWI 3000 commercial contact resistance measurement device available from WSK Mess-und Datentechnik GmbH, Germany. The digital force gauge was equipped with a gold-plated copper alloy probe with a hemispherical tip 2.5 mm in diameter. The electrical resistance of the contact between the gold-plated copper alloy probe and a plurality of brass panels (available from OSSIAN Lagerqvist AB, Sweden) electroplated with the metal layers of silver topcoat/silver-tin alloy/silver undercoat/nickel were measured automatically as a function of the contact force by using the KOWI 3000 integrated current source. Contact resistance was measured at 10mN, 20mN, 30mN, 40mN, 50mN, 60mN, 70mN and 80mN. Thermal aging was done at 200 °C for 500 hours and 200 °C for 1000 hours. A conventional convection oven was used for thermal aging.

Cross-sections of the panels were taken and examined at 10,000X or 15,000X under a ZEISS SEM scanning electron microscope equipped with an EDX.

Each brass panel was coated with 2-3µm of nickel. The silver undercoat and the silver topcoat were electroplated using SILVERJET^{™} 300 SD silver electroplating bath. The silver-tin alloy layer was electroplated using SILVERON^{™} GT-820 silver-tin alloy electroplating bath.

Comparative Example 6 was electroplated with a silver strike layer of about 20nm in place of a silver undercoat layer using a potassium silver cyanide strike bath which included 2 gm/L of silver ions and 100 g/L of free potassium cyanide and Comparative Example 7 was electroplated with a silver strike layer of about 20nm also in place of a silver undercoat layer using SILVERON^{™} GT-101 Strike bath, a cyanide-free silver plating bath. All baths are available from Rohm and Haas Electronic Materials, LLC.

The brass panels were connected to a rectifier and the counter electrode was a platinized titanium electrode. The temperature of the silver and silver-tin alloy baths was 45 °C during electroplating. The baths were stirred during electroplating using a conventional stirring apparatus. The current density ranged from about 1-5 ASD. Electroplating was done until a desired thickness of silver and silver-tin alloy was achieved. Table 1 discloses the thickness of silver and silver-tin alloy electroplated on the nickel coated brass panels. The panels were removed from the plating baths and rinsed with deionized water at room temperature.

**Table 1**

| **EXAMPLE** | **Silver Undercoat (µm)** | **Silver-Tin (µm)** | **Silver Topcoat (µm)** |
|---|---|---|---|
| 1 (Invention) | 1 | 1 | 3 |
| 2 (Invention) | 1 | 0.5 | 3 |
| 3 (Invention) | 1 | 0.1 | 3 |
| 4 (Invention) | 0.5 | 0.25 | 3 |
| 5 (Comparative) | 0 | 2 | 2 |
| 6 (Comparative) | ∼0.02 | 0 | 2 |
| 7 (Comparative) | ∼0.02 | 3 | 0 |

Room temperature contact resistances as measured in mOhms were evaluated for the plated brass panels under various normal forces as shown in Table 2.

**Table 2**

| **EX** | 10mN | 20mN | 30mN | 40mN | 50mN | 60mN | 70mN | 80mN |
|---|---|---|---|---|---|---|---|---|
| 1 | 3 | 2.5 | 2 | 2 | 2 | 1.8 | 1.9 | 2 |
| 2 | 3 | 2.5 | 2.3 | 2 | 2 | 1.8 | 1.8 | 1.8 |
| 3 | 2.5 | 2.5 | 2.5 | 2.5 | 2.5 | 2.5 | 2.5 | 2.5 |
| 4 | 3 | 2.5 | 2.3 | 2 | 2 | 1.8 | 1.9 | 1.9 |
| 5 | 2.9 | 2.6 | 2.3 | 2.2 | 1.9 | 1.8 | 1.8 | 1.7 |
| 6 | 3.7 | 3.2 | 2.8 | 2.5 | 2.5 | 2.2 | 2.3 | 2.3 |
| 7 | 63 | 39.8 | 27 | 18.7 | 14.1 | 12.1 | 10.5 | 10.5 |

As shown in Table 2, the contact resistance of the brass panels plated with the metal layers of the present invention in Examples 1-4 and stored at room temperature for 500 hours or 1000 hours, had reduced contact resistance at the various applied normal forces. The contact resistance of the comparative Examples 5 and 6 was also low as those panels had a silver top layer. In contrast, the comparative Example 7 with a silver-tin alloy as the top layer, had high contact resistance after storing at room temperature owning to the oxidation of the tin present in the alloy.

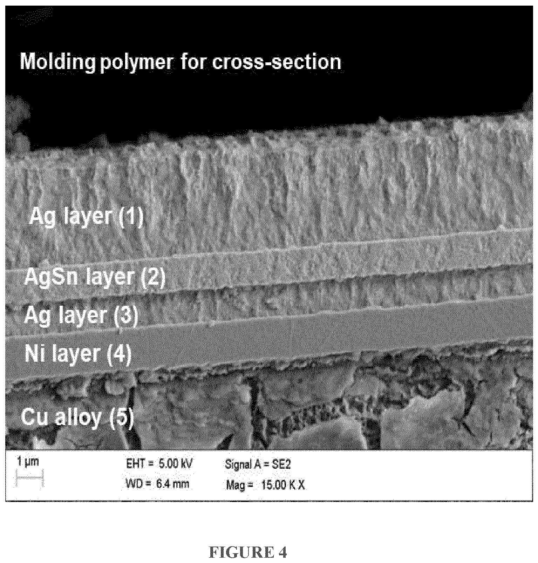

An aliquot of plated brass panels of Examples 1-4 was cut and imbedded in an epoxy-amine molding polymer. Samples of the aliquot were polished and etched using conventional polishing and etching processes known in the art to get the desired cross-section. The cross-section and the metal layers were examined under a ZEISS SEM scanning electron microscope. **Figure 4** is a SEM of one of the plated brass panels at room temperature. Each metal layer can be clearly seen, a silver topcoat **(1)** which is adjacent a silver-tin alloy layer **(2)** which is adjacent a silver undercoat layer **(3)** which is adjacent a nickel barrier layer **(4)** which is adjacent a copper alloy containing substrate **(5).** No separation of the metal layers was observed at the nickel interface. The results for the panels stored at room temperature for 500 hours was the same as those panels stored at room temperature for 1000 hours.

Cross-hatch adhesion tests and bending tests were done on an aliquot of the plated brass panels of Examples 1-7 after storage at room temperature for either 500 hours or 1000 hours. No separation of metal layers was observed for the aliquot.

An aliquot of the plated brass panels from Examples 1 and 3-7 was then heated at 200 °C for 500 hours. After 500 hours the contact resistance of the panels was measured with the results in Table 3 below.

**Table 3**

| **EX** | 10mN | 20mN | 30mN | 40mN | 50mN | 60mN | 70mN | 80mN |
|---|---|---|---|---|---|---|---|---|
| 1 | 11.4 | 7.5 | 5.4 | 3.9 | 3.3 | 3.3 | 2.8 | 2.5 |
| 2 | NA | NA | NA | NA | NA | NA | NA | NA |
| 3 | 11.5 | 7.6 | 5.9 | 4.8 | 4.4 | 4.1 | 3.7 | 3.4 |
| 4 | 3.8 | 3 | 3 | 2.7 | 2.5 | 2.5 | 2.6 | 2.7 |
| 5 | 2090.7 | 1498.5 | 1080.9 | 830.7 | 452.9 | 452.9 | 356.1 | 337 |
| 6 | 7.4 | 4.9 | 4.4 | 4.1 | 3.4 | 3.4 | 3.1 | 3.4 |
| 7 | 1015.6 | 501.4 | 427.5 | 320 | 243.2 | 243.2 | 221.9 | 213.6 |

The contact resistance of the brass panels plated with the metal layers of the present invention in Examples 1, 3 and 4 had low contact resistance at the various normal forces. Comparative Example 6 with pure silver finishing retained a low contact resistance after annealing. In contrast, the comparative Examples 5 and 7 which included thick silver-tin alloy intermediate layers displayed high contact resistances after annealing at 200°C for 500 hours. Examples 1, 3, 4 and comparative Example 5 demonstrated that the thickness of the silver top layer should be higher than the silver-tin alloy intermediate layer to maintain low contact resistance after annealing.

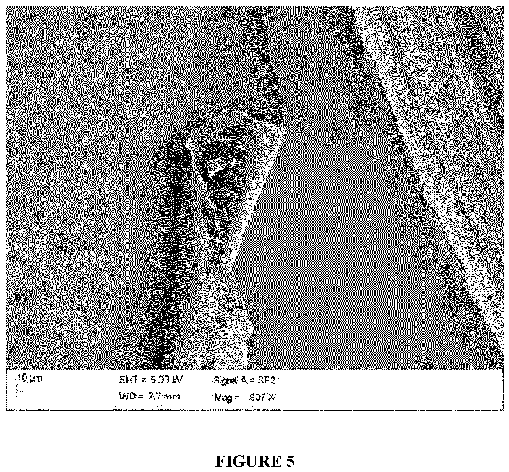

The cross hatch adhesion test and bend test were done on an aliquot of the plated brass panels of Examples 1-4 and of comparative Example 6 after thermal aging at 200 °C for 500 hours. All the samples from comparative Example 6 failed both tests indicating poor adhesion of the silver layers on the nickel after the thermal aging. **Figure 5** is a SEM of one of the plated panels from the aliquot of Example 6 at 807X showing the silver layers detached from the nickel layer at the cross hatch area. All of the plated panels from the aliquots of Examples 1-4 had good adhesion for both the cross hatch test and the bending test. There was no observable adhesion failure for any the samples.

A plurality of electroplated brass panels and copper pins (available from OSSIAN Lagerqvist AB, Sweden) with nickel layers 2-3µm thick and having the metal plated layers as in Table 1 of Examples 1-4 and 7 were stored at 200 °C for 1,000 hours in a conventional convection oven. After 1000 hours the brass panels and pins were removed from the oven and allowed to cool to room temperature. Cross-hatch adhesion tests and bending tests were done on aliquots from Examples 1 to 4. There was no visible separation of layers for the brass panels and copper pins.

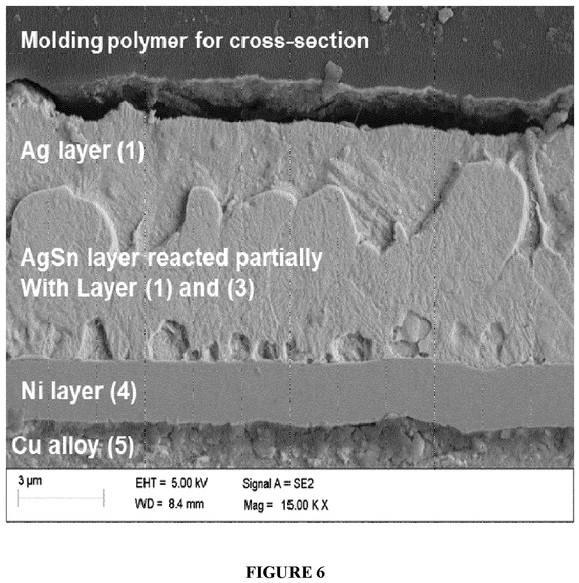

An aliquot of the copper pins was cross sectioned and the metal layers were examined for adhesion performance and voids in the layers. There was no observable separation of the metal layers. **Figure 6** is a SEM at 15000X of one of the plated copper pins of Example 1. All the metal layers appeared joined together without any observable separation and no Kirkendal voids were observed. The silver-tin alloy layer (not distinguishable in the figure) reacted with part of the silver topcoat layer **(1)** and the silver undercoat layer **(3)** such that the boundaries of the silver-tin layer were not clearly defined. The boundaries of the nickel barrier layer **(4)** and the copper alloy containing layer **(5)** are clearly defined. The dark gap at the interface with the silver topcoat **(1)** at the top of **Figure 6** is poor adhesion of the epoxy-amine molding polymer on silver at that specific position.

The tin from the silver-tin alloy layer partially reacted with silver layers **(1)** and **(3)** to form a silver-tin intermetallic. Because the grain boundary of the silver-tin alloy layer was not aligned with that of silver layers **(1)** and **(3),** the silver-tin intermetallic is believed to have blocked oxygen diffusion pathways through the silver layer **(1)** grain boundary, preventing oxygen to move to the nickel surface where oxidation can occur. While not being bound by theory, there was no direct channel or grain boundary passing from the silver topcoat down to the silver under layer and nickel. This was because the grain orientation and grain size of the silver-tin alloy was different from the silver of the silver layers. This lack of direct pathways blocked oxygen atoms from moving down to the nickel surface.

In contrast to the aliquot of Examples 1-4, Kirkendal voids were observed in the cross sections of comparative Example 7 which contained only a very thin silver layer of about 20nm between the silver-tin alloy layer and the nickel layer. The Kirkendal voids can cause adhesion failure after long term use. The present invention increases the thickness of the silver underlayer layer to prevent such void formation after the reaction of tin of the silver-tin alloy layer with the nickel layer.

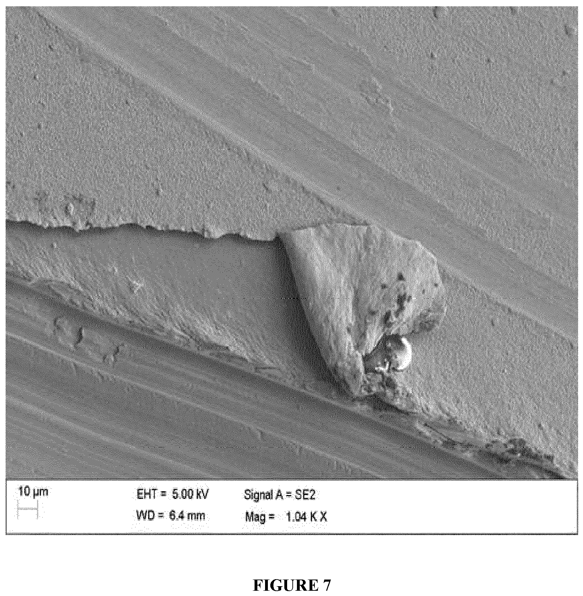

Cross-hatch adhesion tests and bending tests were done on brass panels and copper pins from aliquots of comparative Example 6 after storing at 200 °C for 1000 hours in a conventional oven. All samples failed both tests indicating poor adhesion of the silver layers on the nickel after the thermal aging at 200 °C for 1000 hours. **Figure 7** is a SEM of one of the plated panels at 1040X showing the silver layers detached from the nickel layer.

Contact resistance of an aliquot of the plated brass panels of Examples 1-4 and 7 heated at 200 °C for 1000 hours was measured. The results are in Table 4 below.

**Table 4**

| **EX** | 10mN | 20mN | 30mN | 40mN | 50mN | 60mN | 70mN | 80mN |
|---|---|---|---|---|---|---|---|---|
| 1 | 8.4 | 5.7 | 4.7 | 4.1 | 3.7 | 3.4 | 3.3 | 3.2 |
| 2 | 4.2 | 3.7 | 3.1 | 3.0 | 2.7 | 2.7 | 2.7 | 2.6 |
| 3 | 20.9 | 15.1 | 10.3 | 8.1 | 6.6 | 6.4 | 5.7 | 5.3 |
| 4 | 6.6 | 5.2 | 4.4 | 4.1 | 3.6 | 3.4 | 3.1 | 3.0 |
| 5 | NA | NA | NA | NA | NA | NA | NA | NA |
| 6 | NA | NA | NA | NA | NA | NA | NA | NA |
| 7 | 1086.5 | 1102.7 | 1047.7 | 994.9 | 953.6 | 925.8 | 906.3 | 896.0 |

The contact resistance of the brass panels plated with the metal layers of the present invention in Examples 1-4 had reduced contact resistance at the various applied normal forces in contrast to comparative Example 7. The contact resistance was very high in comparative Example 7 which included a silver strike layer adjacent nickel and a top silver-tin layer adjacent the silver strike layer but excluded a silver topcoat. The high contact resistance is due to the oxidation of tin present in the silver-tin layer. This also demonstrated that a thick pure silver top layer is necessary to keep low contact resistance at temperatures of 200 °C for 1000 hours.

## Claims

1. An article comprising a substrate comprising copper or copper alloy, a nickel or nickel alloy layer adjacent the copper or copper alloy of the substrate, a silver undercoat layer adjacent the nickel layer, a silver-tin alloy layer adjacent the silver undercoat layer and a silver topcoat layer adjacent the silver-tin alloy layer.

2. The article of claim 1, wherein a thickness of the silver undercoat layer is equal to or greater than a thickness of the silver-tin alloy layer.

3. The article of claim 1, wherein a thickness of the silver topcoat layer is greater than a thickness of the silver-tin layer.

4. The article of claim 1, wherein a thickness ratio of the silver topcoat layer to the silver-tin layer is from 2: 1 to 100:1.

5. The article of claim 1, wherein a thickness ratio of the silver undercoat layer to the silver-tin layer is from 1:1 to 40: 1.

6. The article of claim 1, wherein a thickness of the silver undercoat layer is equal to or greater than 0.5 µm.

7. The article of claim 1, wherein a thickness of the silver-tin alloy layer is equal to or greater than 0.1 µm.

8. The article of claim 1, wherein a thickness of the silver topcoat is equal to or greater than 1 µm.

9. A method comprising:
a) providing a substrate comprising copper or copper alloy;
b) depositing a nickel or nickel alloy layer adjacent the copper or copper alloy of the substrate;
c) depositing a silver undercoat layer adjacent the nickel or nickel alloy layer;
d) depositing a silver-tin layer adjacent the silver undercoat layer; and
e) depositing a silver topcoat layer adjacent the silver-tin layer.

10. The method of claim 9, wherein a thickness of the silver undercoat layer is equal to or greater than a thickness of the silver-tin alloy layer.

11. The method of claim 9, wherein a thickness of the silver topcoat layer is greater than a thickness of the silver-tin layer.

12. The method of claim 9, wherein a thickness ratio of the silver topcoat layer to the silver-tin layer is from 2: 1 to 100:1.

13. The method of claim 9, wherein a thickness ratio of the silver undercoat layer to the silver-tin layer is from 1:1 to 40: 1.
